# EUROPEAN PATENT APPLICATION

(11) **EP 0 708 065 A1**
(43) Date of publication of application: **24.04.1996**
(21) Application number: 95116350.0
(22) Date of filing: 17.10.1995
(51) Int. Cl.: C04B 35/111, C23C 16/44

(54) **Plasma fluorine resistant polycristalline alumina ceramic material and method of making**

(30) Priority: 18.10.1994 US 325672
(71) Applicant: APPLIED MATERIALS, INC., Santa Clara, California 95052-8039 (US)
(72) Inventor: Dyer, Timothy S., Cupertino, California 95014 (US); Cheng, Tsungnan, Saratoga, California 95070 (US)
(74) Representative: Kahler, Kurt, Dipl.-Ing.

(57) **Abstract**

A plasma fluorine resistant polycrystalline alumina ceramic material includes between about 99.5% and 99.8% by weight of alumina and about 0.5% to 0.2% by weight of a binder and has a unimodal grain size distribution.

## Description

### Background of the Invention

### 1. Field of the Invention

The present invention relates to an improved alumina ceramic material which is highly resistant to etching by fluorine plasmas. The present invention further relates to a method for making the improved ceramic material, and to articles of manufacture, such as components of semiconductor processing devices, comprising the improved ceramic material.

### 2. Description of the Related Art

Semiconductor processing devices generally require components which are resistant to harsh chemical environments. For example, high density fluorine plasma environments are typically generated in chemical vapor deposition (CVD) reactors during chamber cleaning processes. Plasma fluorine liberated from fluorocarbon and other fluorine-containing gases (for example, CF₄:O₂ plasmas) is used to remove dielectric film residues deposited in the chambers of CVD reactors. Fluorine plasmas are also used for etching of oxide films on semiconductor wafers. Such plasmas, which are characterized by very low pressure, low ion energy (4 to 10 eV) and high ion density, are particularly corrosive.

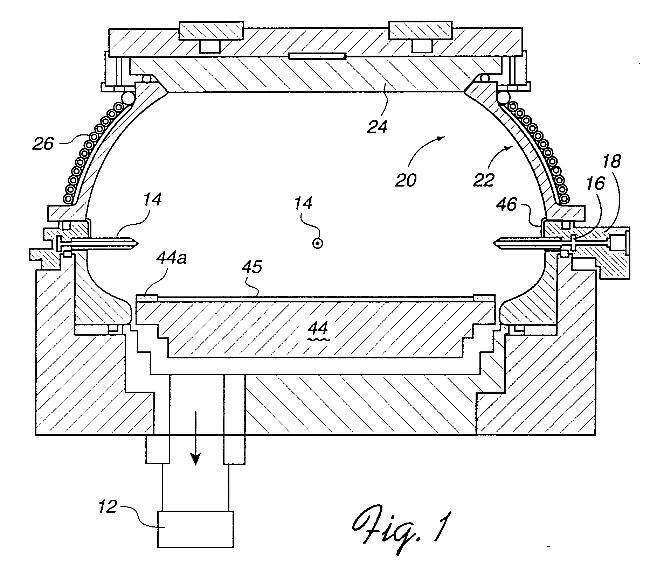

Ceramic materials can be employed to produce components of CVD reactors, such as the reactor described in U.S. Patent Application Serial No. 08/234,746, to Nowak et al., filed April 26, 1994. An exemplary CVD reactor is shown in Figure 1. The exemplary reactor includes a vacuum chamber 10, a vacuum pump 12, and gas injection nozzles 14 connected to a gas supply ring manifold 16 in a metal housing 18 supporting the injection nozzles 14. The chamber 10 has walls and a ceiling 20 consisting of a partial dome-shaped or hemispherical annulus 22 surrounding a planar disk 24. The dome-shaped annulus 22 is comprised of an insulator, and supports a helically coiled RF antenna 26. The ceiling 24 is comprised of a conductor. The bottom of the chamber 10 may include a wafer pedestal 44 for holding a wafer 45, and preferably a dielectric annulus 44a which is coplanar with the top surface of wafer 45 and surrounds wafer 45. The wafer pedestal 44 may include features such as a chuck, particularly an electrostatic chuck.

In the exemplary reactor of Figure 1, components including gas injection nozzles 14, hemispherical annulus 22, wafer pedestal 44 and dielectric annulus 44a, beneficially are comprised of a plasma fluorine resistant material, such as a ceramic material. Other components commonly employed in the processing of semiconductors, such as heater plates, susceptors, shield rings and wafer boats, also are beneficially comprised of such a material.

Most materials, whether man-made or naturally occurring, are insufficiently resistant to plasma fluorine, and etch very quickly in plasma fluorine environments. Few known materials are capable of withstanding high density fluorine plasmas. Theoretically, high purity alumina ceramics, such as sapphire or 99.9% alumina, have been expected to show prolonged resistance to low energy, high density fluorine plasma (see, e.g., Lee *et al, J. Appl. Phys*. **68** (10), 15 November 1990). It is believed that such materials form an aluminum fluoride (AIF) layer upon exposure to fluorine plasma, which acts to passivate the material. Sapphire, which is pure single-crystal alumina, is one of the slowest etching materials known to be tested and used in a high density plasma fluorine environment, having an etch rate of about 50 Å/hour in a low energy (4-10 eV), high density fluorine plasma at a temperature of 573-650 K.

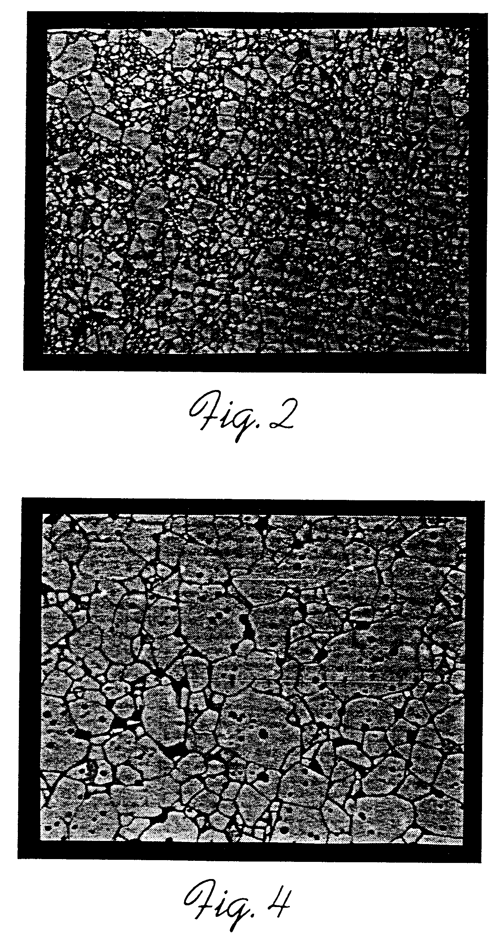

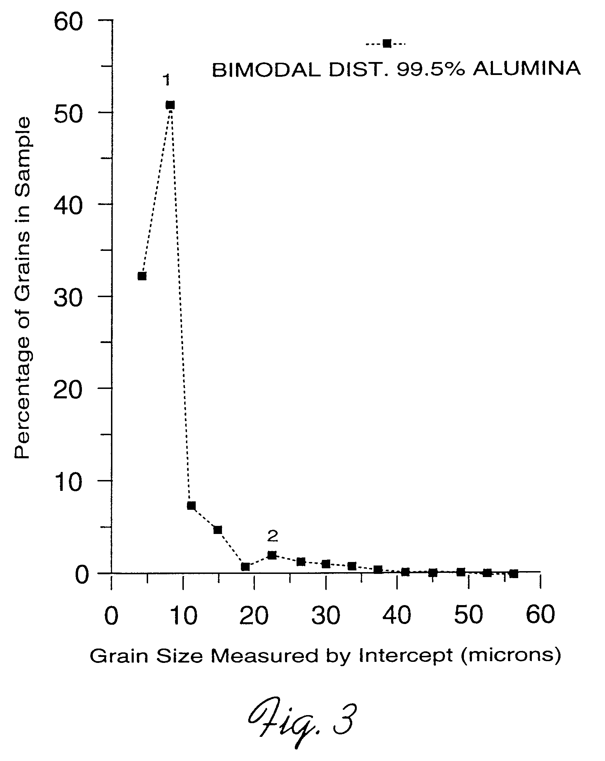

However, under the same conditions, polycrystalline alumina ceramics have been observed to etch at rates from 300 to 2000 Å. Polycrystalline alumina ceramics typically include about 99.5-99.9% alumina and about 0.5-0.1% of a binder phase, such as silica. Typical industrial polycrystalline alumina ceramics show a microstructure with a bimodal distribution in grain size (*i.e.,* a distribution having two most frequent values for the grain size over the entire range of grain sizes), such as that shown in Figure 2. Figure 3 illustrates a typical bimodal grain size distribution for such a prior art polycrystalline alumina ceramic.

The bimodal microstructure of the prior art polycrystalline alumina ceramics leads to superior physical strength for the ceramics. However, as a consequence of the bimodal grain size distribution, such alumina ceramics typically include large silica-rich areas surrounding small grains. Such silica-rich areas are readily visible in Figure 2. The silica-rich areas are highly susceptible to fluorine attack, typically etching at a rate up to 96000 Å/hour or more upon exposure to low energy, high density plasma fluorine. With loss of the silica binder, the small particles of alumina embedded therein are liberated (so-called "grain pull-out") and form particles of aluminum oxyfluoride. As a result, the known alumina ceramics often disintegrate, with emission of particles of aluminum oxyfluoride, typically from 0.1 to 2 µm in diameter, into the CVD chamber.

It would be desirable to provide a polycrystalline alumina ceramic material which shows improved resistance to plasma fluorine. Such a material would find ready applicability, for example, in the production of components useful in vacuum processing devices such as CVD and etch chambers. It would further be desirable to provide an improved method for producing the novel ceramic material.

### Summary of the Preferred Embodiments

In accordance with one aspect of the present invention, there is provided a plasma fluorine resistant polycrystalline alumina ceramic material.

In a more particular aspect of the invention, the ceramic material comprises between about 99.5% and 99.8% by weight of alumina and about 0.5% to 0.2% by weight of a binder.

In another more particular aspect of the invention, the alumina ceramic material has a unimodal grain size distribution, in particular a distribution centered between about 15 µm and 30 µm.

In accordance with another aspect of the present invention, a method of producing a plasma fluorine resistant polycrystalline alumina ceramic material includes the steps of forming a green body from a powder including from about 99.5 wt% to 99.8 wt% alumina and about 0.5 wt% to 0.2 wt% of a binder and having a unimodal grain size distribution, and sintering the green body.

In accordance with further aspects of the present invention, there are provided a ceramic material produced according to a method as described above, and an article of manufacture comprising a ceramic material as described above.

Other objects, features and advantages of the present invention will become apparent to those skilled in the art from the following detailed description. It is to be understood, however, that the detailed description and specific examples, while indicating preferred embodiments of the present invention, are given by way of illustration and not limitation. Many changes and modifications within the scope of the present invention may be made without departing from the spirit thereof, and the invention includes all such modifications.

### Brief Description of the Drawings

The invention may be more readily understood by referring to the accompanying drawings in which
FIG. 1 is a cross-sectional representation of an exemplary CVD reactor, showing various components thereof which beneficially are comprised of a polycrystalline alumina ceramic material according to the present invention,
FIG. 2 is an optical photomicrograph of a prior art polycrystalline alumina ceramic material at a magnification of 266x, showing a bimodal distribution of grain sizes having an average grain size of 6.8 µm,
FIG. 3 is a graph of grain size vs. number for a prior art alumina ceramic material having a bimodal distribution of grain sizes,
FIG. 4 is an optical photomicrograph of a polycrystalline alumina ceramic material according to the present invention, also at a magnification of 266x, showing a unimodal distribution of grain sizes having an average grain size of 20 µm,
FIG. 5 is a graph of grain size vs. number for the inventive polycrystalline alumina ceramic material of FIG. 3, illustrating the unimodal distribution of grain sizes,
FIG. 6 is a graph of etch rate vs. time, using a CF₄:O₂ 10:1 ICP plasma (30 mTorr, 2500 W), for a 99.5 wt% alumina ceramic material with silica binder according to the invention (■), a high-purity (99.9 wt% ) polycrystalline alumina (●) and sapphire (▲), the exposed surfaces of each of which were ground prior to exposure, showing the long-term convergence of etch rates for the inventive materials to the sapphire etch rate,
FIGS. 7a-c illustrate the grain boundary aspect ratio for a 99.5% alumina ceramic material of the invention at 0, 5 and 35 hours plasma fluorine exposure, respectively, and
FIGS. 8a-b are scanning electron microscope (SEM) photographs, at a magnification of 4000x, of a comparison high-purity 99.9 wt% polycrystalline alumina ceramic material before exposure and after 35 hours exposure to plasma fluorine, illustrating surface damage to a prior art material resulting from exposure to the plasma.

### Detailed Description of the Preferred Embodiments

We have discovered that a polycrystalline alumina ceramic material having a unimodal distribution of grain size is highly resistant to plasma fluorine attack.

### 1. Properties of the inventive materials

The inventive material comprises from about 99.5 wt% to about 99.8 wt% alumina. The remaining about 0.5 wt% to 0.2 wt% comprises a binder, typically a mixture of silica, CaO and MgO. It is beneficial to include MgO in the binder to help control grain growth.

The material is characterized by a unimodal distribution of alumina grain sizes. The term "unimodal" denotes that the distribution has a single most frequent value, *i.e.,* mode, for grain size, as opposed to the two most frequent values of a bimodal distribution.

Preferably, the distribution is centered between about 15 µm and 30 µm, more preferably between about 20 and 25 µm. That is, the mode of the distribution falls between the foregoing values. The distribution furthermore preferably includes less than 10% of grains having a size below about 10 µm and less than 10 of grains having a size above about 30 µm.

Unimodal distributions centered at a grain size much smaller than about 15 µm, particularly less than about 8 µm to 12 µm, yield ceramic materials which show inadequate resistance to plasma fluorine, particularly when an amount of binder greater than about 0.5 wt% is also employed. Unimodal distributions centered at a grain size significantly larger than 25 µm may yield ceramic materials having inadequate strength (strength being inversely proportional to the square root of grain size).

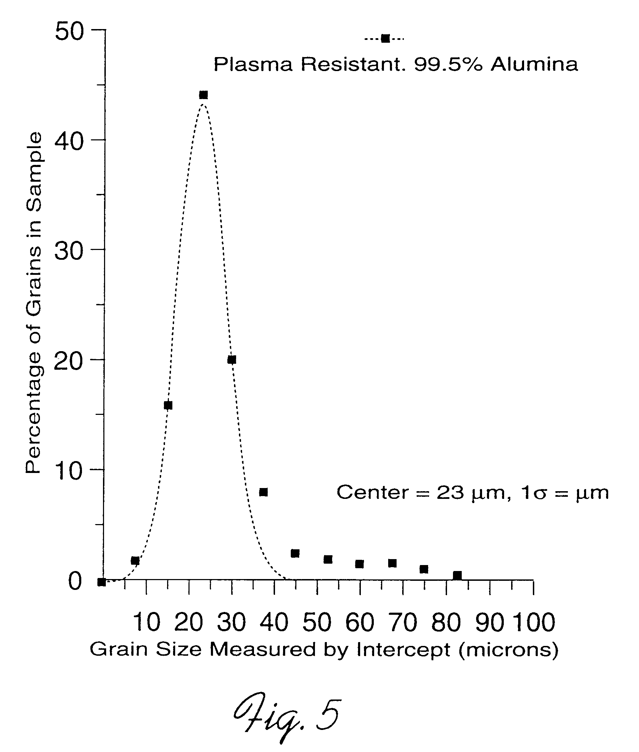

Figure 4 illustrates an exemplary polycrystalline alumina ceramic material of the invention. In comparison with the material shown in Figure 2, the exemplary inventive material shows far fewer silica-rich regions surrounding isolated small grains. The unimodal distribution of grain sizes characteristic of the exemplary inventive material is shown in Figure 5.

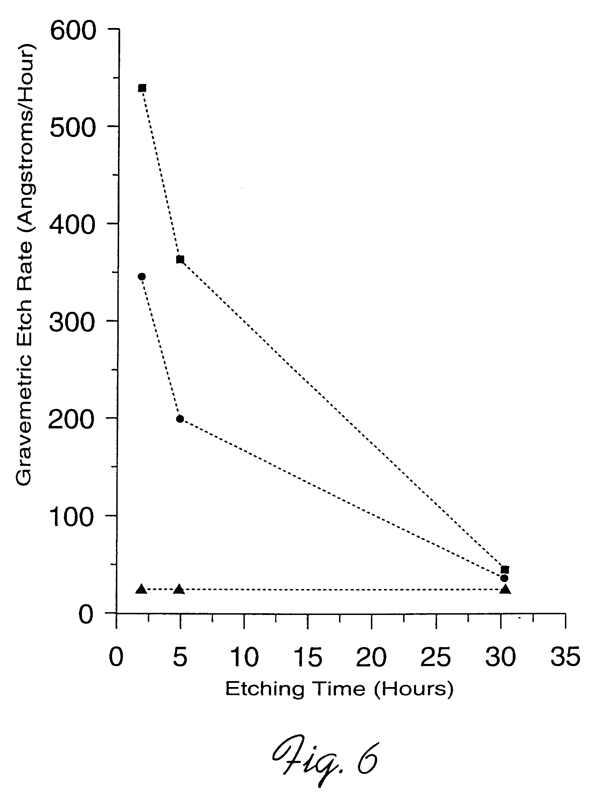

The inventive materials are characterized by excellent resistance to a fluorine plasma. Average gravimetric etch rates of about 150 Å/hour, calculated in the basis of a 20 hour exposure to plasma fluorine, are readily achieved. Long-term gravimetric etch rates, measured after 35 hours of exposure to plasma fluorine, are observed to converge to approximately the etch rate of sapphire, or about 50 Å/hour. See Figure 6.

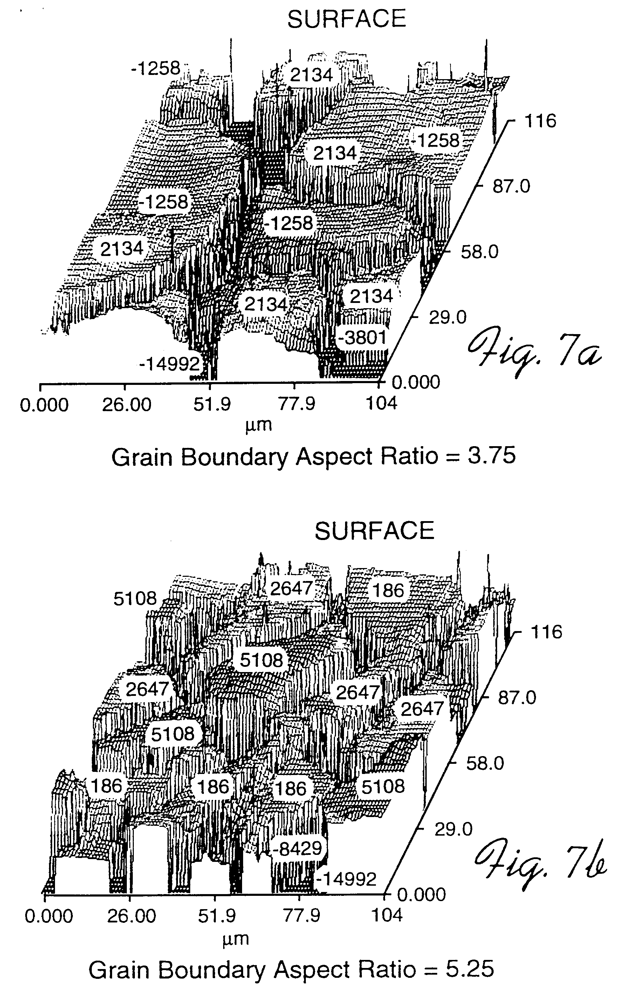

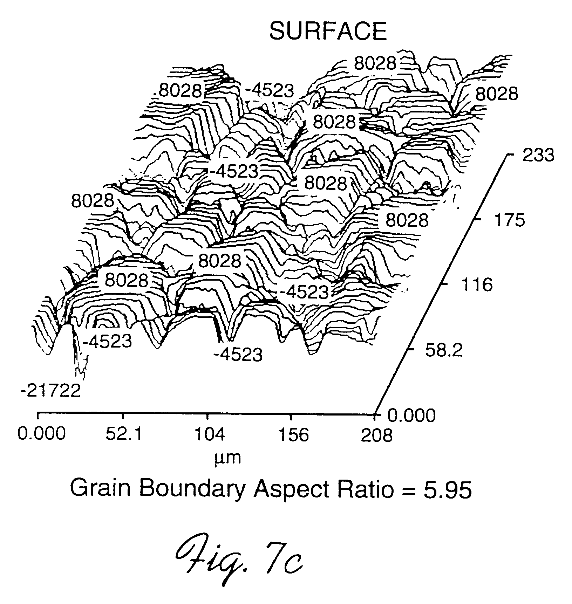

Observed gravimetric etch rates are non-linear with time, as shown in Figure 6. The inventive ceramic material (●) initially etches fairly rapidly. This reflects removal of a surface silica phase, which is produced during firing of the inventive materials. After the surface silica phase is removed, the apparent etch rate decreases. In this regime the plasma etches the silica binder phase along the grain boundaries. As etching proceeds, the aspect ratio (height to width) of the grain boundaries increases, as shown in Figures 7a, 7b and 7c, which show the aspect ratio of the grain boundaries after 0, 5 and 35 hours of exposure of a sample of a 99.5% alumina ceramic material of the invention to a fluorine plasma. Once the aspect ratio exceeds an average value of about 5, the plasma no longer effectively penetrates into the grain boundaries to continue etching the silica binder. Accordingly, at long exposure times the etch rate approaches that of sapphire (▲).

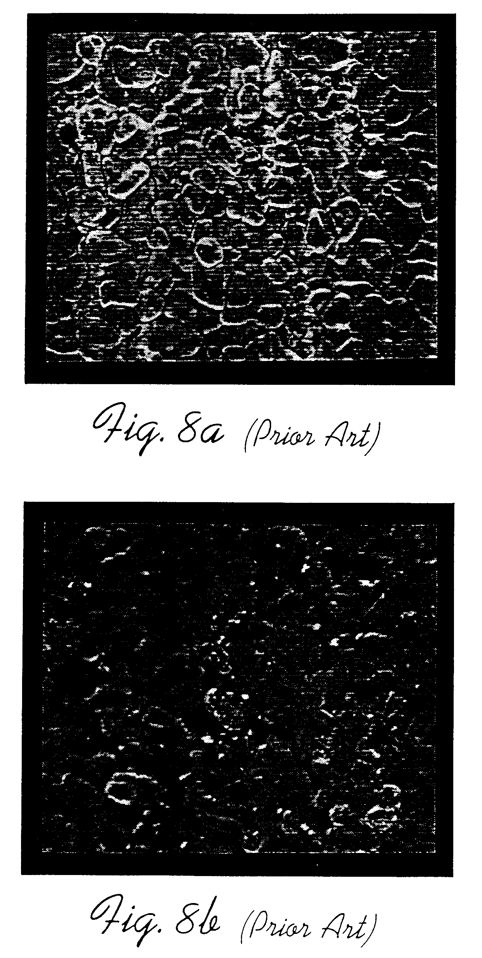

The comparison high purity alumina (●) shows similar etching behavior in all regimes, although at reduced gravimetric etching rates. The reduced etching rate is believed to be due to the lesser volume of silica present in the material. However, although improved gravimetric etch resistance is obtained, the high purity alumina suffers from higher grain pull-out than the inventive alumina, as evidenced by comparison of Figures 8a and 8b. The higher grain pull-out is likewise attributed to the low volume of silica present. It is believed that the high purity material does not have a sufficient volume of binder to evolve adequate intra-granular adhesion, and therefore liberates particles more readily than materials having a lower purity and hence a larger volume of binder.

Etch rates for individual alumina grains within the inventive ceramic materials have been found to be very low (< 100 Å/hour).

Polycrystalline alumina ceramic materials of the invention have very desirable physical properties, including high strength, density and thermal shock resistance. Typical compressive strength is at least 300,000 psi. Flexural strength is typically at least 40,000 psi. Density after sintering is typically at least about 3.75 g/cm³. Thermal shock ΔT is typically about 200°C.

### 2. Production of the inventive materials

The process for producing a polycrystalline alumina ceramic material of the invention includes control of the initial distribution of grain sizes in the powdered material used to form the initial green body, and control of the firing sequence employed during sintering of the green body to produce the desired final product.

Initially, a powder comprising about 99.5 wt% to 99.8 wt% alumina and the balance a selected binder, and having a unimodal grain size distribution, is produced. Such a distribution can be produced, for example, by a milling process such as ball milling followed by sieving to obtain the desired distribution. Other milling processes, preferably also followed by a sieving step, can also be employed. The initial unimodal grain size distribution preferably is centered from about 0.5 µm to about 2.0 µm.

Once the desired unimodal grain size distribution has been produced, the alumina powder is formed into a green body (i.e., the initial unsintered body which comprises compacted powder). In forming the green body, it is desirable to control the dimensions of the body such that uniformity of temperature is realized during sintering.

It is particularly beneficial to form the green body into the desired final shape, so that no additional machining is required after sintering. The resulting "as-fired" article, as discussed in more detail below, shows particularly improved resistance to plasma fluorine.

The pressure employed to produce the green body preferably ranges from about 5000 to 14000 psia, more preferably about 7000 to 10000 psia. Initial green body density preferably ranges from about 1.8 to 2.2 g/cm³.

Once the green body is formed, it is subjected to pressureless sintering (i.e., sintering at ambient pressure) at a temperature and for a time sufficient to achieve the final desired unimodal distribution of grain sizes, preferably between about 15 µm and 30 µm, and also a density sufficient to achieve acceptable strength, preferably at least 3.75 g/cm³, typically about 3.8 g/cm³. Minimum compressive strength preferably is about 300,000 psi. Minimum flexural strength preferably is about 40,000 psi.

Preferably, the pressureless sintering process is carried out in air at a temperature from about 1400 to 1700°C, preferably about 1600 to 1650°C, for a time between 1 and 10 hours, preferably about 7 and 8 hours.

The inventive process affords a plasma fluorine resistant alumina ceramic material which can be employed in forming a variety of articles of manufacture, preferably for use in environments wherein they are subject to plasma fluorine exposure. Such articles of manufacture include, for example, bell jars, crucibles, and components for use with a vacuum processing apparatus. More specific articles of manufacture within the scope of the instant invention include vacuum processing apparatus components such as a chuck, a nozzle, a susceptor, a heater plate, a clamping ring, a shield ring, a wafer boat, or a chamber wall. Such articles of manufacture can be comprised entirely or substantially of a ceramic material of the invention, or can have one or more surfaces or portions thereof having layers which comprise a ceramic material of the invention.

Surprisingly, average etch rates for ceramic materials having surfaces which are exposed to plasma fluorine without post-firing machining, such as grinding or lapping, show even greater resistance to fluorine attack. Such "as-fired" materials etch at rates up to 20% less than otherwise identical materials which are machined post-firing. Etch rates of less than about 130 Å/hour (based on 20 hours exposure) are readily realized for these materials.

The instant invention is further illustrated by reference to the following non-limiting example.

### Example 1

A polycrystalline alumina ceramic material having a unimodal grain size distribution was produced as follows. An alumina powder was produced by milling in a ball mill for 6 hours. The powder was sieved to yield a powder having a unimodal grain size distribution centered at 2 µm, and combined with powdered silica to afford a composition comprising 99.5 wt% alumina, 0.3 wt% silica and the balance MgO and CaO.

The composition was formed into green bodies having dimensions of 2.5 cm in diameter by 1.0 cm in thickness and a density of 2.2 g/cm³ under a pressure of 8000 psia. Pressureless sintering of the green bodies was then carried out in air at 1600°C for 8 hours. The resulting polycrystalline alumina ceramic materials had a density of 3.8 g/cm³ and a unimodal grain size distribution centered at 20 µm.

The inventive materials were either machined post-firing (by grinding) or maintained in the "as-fired" state, and then exposed to a CF₄:O₂ plasma having the following parameters:

| | |
|---|---|
| Composition | CF₄:O₂, 10:1 flow ratio |
| Pressure | 30 mTorr |
| Coupon temperature | 300°C |
| Plasma potential | 10 V |
| RF power | 2500 W |
| Plasma density | 5 x 10¹¹ ions/cm³ |
| RGA ion analysis | CF₃, CF₂, CF, F, O (decreasing order of concentration) |

The inventive material was exposed for 20 hours.

Comparison coupons comprised of known alumina and aluminum nitride ceramic materials, and sapphire, were processed and exposed to plasma in a like manner.

Gravimetric etch rates were calculated for each material based on weight loss measurements and true density calculations based on 20 hours exposure. Results are given below (maximum error ± 15 Å/hour).

| Ceramic | Etch Rate, Å/hour | |
|---|---|---|
| | Ground | As-Fired |
| Wesgo Al-995 99.5% alumina | 438 | 320 |
| Kyocera A479 99.5% alumina | 440 | -- |
| Kyocera A480 99.95% alumina | 830 | -- |
| Kyocera SA-100 Single crystal sapphire | 70 | 70 |
| NGK AN-11 99.9% aluminum nitride | 153 | -- |
| Invention | 152 | 127 |

As is evident from the foregoing table, the inventive polycrystalline alumina ceramic material shows superior resistance to plasma fluorine in comparison to known polycrystalline aluminas, and compares favorably to aluminum nitride and sapphire.

The inventive material overcomes the difficulties associated with prior art alumina ceramic materials with respect to grain pull-out, is simple to manufacture and provides a medium for inexpensive mass production of vacuum deposition apparatus components and other articles of manufacture.

## Claims

1. A plasma fluorine resistant polycrystalline alumina ceramic material.

2. The ceramic material of claim 1 having a unimodal grain size distribution.

3. The ceramic material of claim 2 wherein said unimodal grain size distribution is centered between about 15 µm and about 30 µm.

4. A plasma fluorine resistant polycrystalline alumina ceramic material comprising between about 99.5 wt% and 99.8 wt% by weight of alumina and about 0.5 wt% to 0.2 wt% of a binder and having a unimodal grain size distribution centered between about 15 µm and about 30 µm.

5. A method of producing a plasma fluorine resistant polycrystalline alumina ceramic material comprising the steps of
(i) forming a green body from a powder including from about 99.5 wt% to 99.8 wt% alumina and about 0.5 wt% to 0.2 wt% of a binder and having a unimodal grain size distribution, and
(ii) sintering said green body.

6. A ceramic material produced by the method of claim 5.

7. An article of manufacture comprising the ceramic material of claim 1.

8. An article of manufacture comprising the ceramic material of claim 4.

9. The article of manufacture of claim 7 which is a component for use with a vacuum processing apparatus.

10. The article of manufacture of claim 9 which is selected from the group consisting of a chuck, a nozzle, a susceptor, a heater plate, a clamping ring, a shield ring, a wafer boat, and a chamber wall.
